# EUROPEAN PATENT APPLICATION

(11) **EP 2 243 867 A1**
(43) Date of publication of application: **27.10.2010**
(21) Application number: 08870763.3
(22) Date of filing: 24.12.2008
(51) Int. Cl.: C30B 29/38, C30B 25/16

(54) **METHOD FOR GROWING GALLIUM NITRIDE CRYSTAL AND METHOD FOR PRODUCING GALLIUM NITRIDE SUBSTRATE**

(30) Priority: 18.01.2008 JP 2008009349
(71) Applicant: Sumitomo Electric Industries, Ltd., Chuo-ku Osaka-shi Osaka 541-0041 (JP)
(72) Inventor: TAKEYAMA, Tomoharu, Itami-shi Hyogo 664-0016 (JP)
(74) Representative: Grünecker, Kinkeldey, Stockmair & Schwanhäusser Anwaltssozietät
(86) International application number: PCT/JP2008/073432
(87) International publication number: WO 2009/090840

(57) **Abstract**

In a method of growing a gallium nitride crystal, the following steps are performed. First, a base substrate is prepared (step S1). Then, a first gallium nitride layer is grown on the base substrate (step S2). Thereafter, a second gallium nitride layer less brittle than the first gallium nitride layer is grown (step S3).

## Description

### TECHNICAL FIELD

The present invention relates to a method of growing a gallium nitride crystal and a method of manufacturing a gallium nitride substrate.

### BACKGROUND ART

A GaN (gallium nitride) substrate having an energy band gap of 3.4 eV and high thermal conductivity has been receiving attention as a material for semiconductor devices such as an optical device of short wavelength and a power electronic device. Methods of manufacturing a gallium nitride substrate are disclosed in Japanese Patent Laying-Open No. 2000-44400 (Patent Document 1), Japanese Patent Laying-Open No. 2002-373864 (Patent Document 2), and the like.

Patent Document 1 discloses a method of manufacturing a GaN single crystal substrate as follows. Specifically, a mask having openings is provided on a GaAs (gallium arsenide) substrate. Then, a GaN buffer layer is formed in the openings of the mask with HVPE (Hydride Vapor Phase Epitaxy) or MOCVD (Metal Organic Chemical Vapor Deposition). Then, a GaN epitaxial layer is formed to cover the mask with HVPE or MOCVD. Thereafter, the GaAs substrate is removed by etching, and the mask is removed by polishing.

Patent Document 2 discloses a method of manufacturing a GaN single crystal layer as follows. Specifically, a GaN crystal is grown on a GaN seed crystal with HVPE. Then, the GaN seed crystal is removed by grinding.
Patent Document 1: Japanese Patent Laying-Open No. 2000-44400
Patent Document 2: Japanese Patent Laying-Open No. 2002-373864

### DISCLOSURE OF THE INVENTION

### PROBLEMS TO BE SOLVED BY THE INVENTION

In order to manufacture a GaN single crystal substrate, a base substrate and a mask need to be removed. Polishing is carried out in order to remove a mask in Patent Document 1, and grinding is carried out in order to remove a base substrate in Patent Document 2. Polishing and grinding causes application of mechanical impact to a GaN single crystal layer being manufactured, which results in occurrence of a crack in the GaN single crystal layer.

In view of the above, the present invention provides a method of growing a gallium nitride crystal and a method of manufacturing a gallium nitride substrate capable of achieving suppressed occurrence of a crack in a manufacturing process.

### MEANS FOR SOLVING THE PROBLEMS

In a method of growing a gallium nitride crystal according to the present invention, the following steps are performed. First, a base substrate is prepared. Then, a first gallium nitride layer is grown on the base substrate. Thereafter, a second gallium nitride layer less brittle than the first gallium nitride layer is grown.

According to the method of growing a gallium nitride crystal of the present invention, the first gallium nitride layer more brittle than the second gallium nitride layer is grown, so that the brittle first gallium nitride layer and the second gallium nitride layer can be grown on the base substrate. When impact is applied from a base substrate side in order to remove the base substrate in this state, the first gallium nitride layer, which is more brittle than the second gallium nitride layer, fractures prior to the second gallium nitride layer due to the impact, and the first gallium nitride layer readily separates from the second gallium nitride layer. In addition, when impact is applied to the first gallium nitride layer in order to remove the base substrate, the first gallium nitride layer separates from the second gallium nitride layer under small impact. If the first gallium nitride layer adheres to the second gallium nitride layer after separating from the second gallium nitride layer, the first gallium nitride layer can be removed from the second gallium nitride layer with small impact, thereby reducing occurrence of a crack in the second gallium nitride layer. Therefore, a gallium nitride crystal in which occurrence of a crack is suppressed in a manufacturing process can be grown.

In the method of growing a gallium nitride crystal described above, preferably, the first gallium nitride layer contains oxygen as a first dopant, the second gallium nitride layer contains oxygen as a second dopant, and oxygen concentration in the first dopant is higher than oxygen concentration in the second dopant.

In the method of growing a gallium nitride crystal described above, preferably, the first gallium nitride layer contains silicon as a first dopant, the second gallium nitride layer contains silicon as a second dopant, and silicon concentration in the first dopant is higher than silicon concentration in the second dopant.

In the method of growing a gallium nitride crystal described above, preferably, the first gallium nitride layer contains oxygen as a first dopant, the second gallium nitride layer contains silicon as a second dopant, and oxygen concentration in the first dopant is not smaller than 33/50 of silicon concentration in the second dopant.

In the method of growing a gallium nitride crystal described above, preferably, the first gallium nitride layer contains oxygen and silicon as a first dopant, oxygen concentration in the first dopant is equal to or higher than silicon concentration in the first dopant in the first gallium nitride layer, the second gallium nitride layer contains silicon as a second dopant, and a sum of the oxygen concentration and the silicon concentration in the first dopant is equal to or higher than silicon concentration in the second dopant.

The present inventor earnestly studied conditions for the first gallium nitride layer to be less brittle than the second gallium nitride layer, and found the conditions described above. By using any of the above-described conditions of dopants in the first and second gallium nitride layers, the first gallium nitride layer has larger lattice strain than in the second gallium nitride layer, which renders the first gallium nitride layer more brittle than the second gallium nitride layer. Consequently, the first gallium nitride layer can be readily separated from the second gallium nitride layer.

In the method of growing a gallium nitride crystal described above, preferably, the base substrate is made of a material different from gallium nitride.

Even if the base substrate is a different type substrate, occurrence of a crack in the second gallium nitride layer can be suppressed in the manufacturing process by lowering brittleness of the first gallium nitride layer.

The method of growing a gallium nitride crystal described above preferably further includes the step of forming a mask layer having an opening on the base substrate between the step of preparation and the step of growing the first gallium nitride layer.

As a result, an area of the base substrate exposed through the opening of the mask layer can be reduced, thereby suppressing transfer of dislocation formed in the base substrate to the first gallium nitride layer. Accordingly, occurrence of dislocation in the second gallium nitride layer can be suppressed.

The method of growing a gallium nitride crystal described above preferably further includes the steps of, between the step of preparation and the step of growing the first gallium nitride layer, forming a buffer layer on a different type substrate, and forming a mask layer having an opening on the buffer layer.

As a result, an area of the base substrate exposed through the opening of the mask layer can be reduced, thereby suppressing transfer of dislocation formed in the base substrate to the first gallium nitride layer. Accordingly, occurrence of dislocation in the second gallium nitride layer can be suppressed. Further, a crystalline property of the second gallium nitride layer can be further improved by forming the buffer layer.

In the method of growing a gallium nitride crystal described above, preferably, a material constituting the mask layer includes at least one substance selected from the group consisting of silicon dioxide (SiO2), silicon nitride (Si₃N₄), titanium (Ti), chromium (Cr), iron (Fe), and platinum (Pt).

Since the opening is readily formed uniformly with these materials, transfer of dislocation formed in the base substrate to the first gallium nitride layer can be suppressed. Therefore, occurrence of dislocation in the second gallium nitride layer can be further suppressed.

A method of manufacturing a gallium nitride substrate according to the present invention includes the steps of growing the first and second gallium nitride layers with any of the methods of growing a gallium nitride crystal described above, and removing the base substrate and the first gallium nitride layer from the second gallium nitride layer.

According to the method of manufacturing a gallium nitride substrate of the present invention, the first gallium nitride layer more brittle than the second gallium nitride layer is grown. Thus, when impact is applied in order to remove the base substrate, the first gallium nitride layer fractures prior to the second gallium nitride layer, and the first gallium nitride layer readily separates from the second gallium nitride layer. If the second gallium nitride layer and the first gallium nitride layer are adhered to each other after the separation, the first gallium nitride layer can be removed from the second gallium nitride layer with small impact, thereby reducing occurrence of a crack in the second gallium nitride layer. Therefore, a gallium nitride substrate in which occurrence of a crack is suppressed can be manufactured.

### EFFECTS OF THE INVENTION

According to the method of growing gallium a nitride crystal and the method of manufacturing a gallium nitride substrate of the present invention, occurrence of a crack can be suppressed in a manufacturing process.

### BRIEF DESCRIPTION OF THE DRAWINGS

Fig. 1 is a flowchart illustrating a method of manufacturing a gallium nitride substrate in a first embodiment of the present invention.
Fig. 2 is a schematic cross-sectional view showing a base substrate in the first embodiment of the present invention.
Fig. 3 is a schematic cross-sectional view showing a grown separation layer in the first embodiment of the present invention.
Fig. 4 is a schematic cross-sectional view showing a grown GaN layer in the first embodiment of the present invention.
Fig. 5 is a schematic cross-sectional view showing separation layer and GaN layer cut from each other in the first embodiment of the present invention.
Fig. 6 is a schematic cross-sectional view showing a GaN substrate in the first embodiment of the present invention.
Fig. 7 is a flowchart illustrating a method of manufacturing a GaN substrate in a second embodiment of the present invention.
Fig. 8 is a schematic cross-sectional view showing a formed mask layer in the second embodiment of the present invention.
Fig. 9 is a schematic cross-sectional view showing a grown separation layer in the second embodiment of the present invention.
Fig. 10 is a schematic cross-sectional view showing a grown GaN layer in the second embodiment of the present invention.
Fig. 11 is a flowchart illustrating a method of manufacturing a GaN substrate in a third embodiment of the present invention.
Fig. 12 is a schematic cross-sectional view showing a formed buffer layer in the third embodiment of the present invention.
Fig. 13 is a schematic cross-sectional view showing a formed mask layer in the third embodiment of the present invention.
Fig. 14 is a schematic cross-sectional view showing a formed separation layer in the third embodiment of the present invention.
Fig. 15 is a schematic cross-sectional view showing a grown GaN layer in the third embodiment of the present invention.
Fig. 16 illustrates relation between oxygen concentration and silicon concentration in a separation layer for samples 4, 7 and 9 to 11 in which the GaN layer was doped with silicon in concentration of 6x 10¹⁸cm⁻³ in the present embodiment.

### DESCRIPTION OF THE REFERENCE SIGNS

10 GaN substrate; 11 base substrate; 12 separation layer; 13 GaN layer; 14 mask layer; 14a opening; 15 buffer layer.

### BEST MODES FOR CARRYING OUT THE INVENTION

Embodiments of the present invention will be described below with reference to the drawings.

### (First Embodiment)

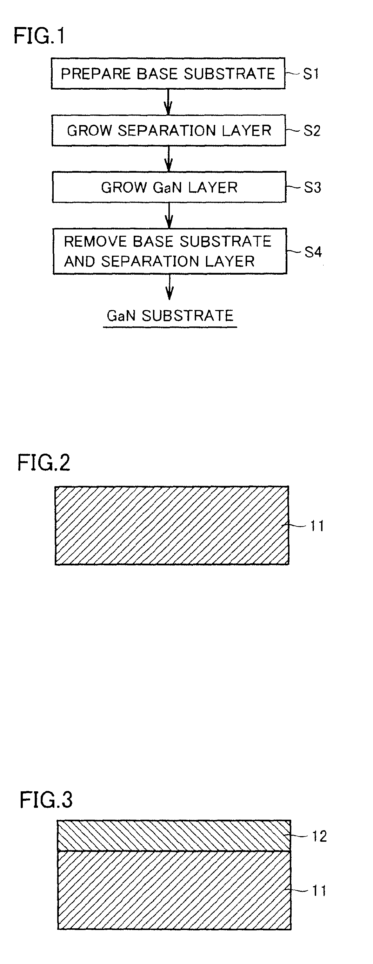

Fig. 1 is a flowchart illustrating a method of manufacturing a GaN substrate in the present embodiment. Referring to Fig. 1, a method of growing a crystal in a GaN layer and a method of manufacturing a GaN substrate in the present embodiment will be described.

Fig. 2 is a schematic cross-sectional view showing a base substrate 11 in the present embodiment. As shown in Figs. 1 and 2, first, base substrate 11 is prepared (step S1). Base substrate 11 to be prepared may be made of GaN or a material different from GaN, and is preferably a different type substrate made of a material different from GaN. Gallium arsenide (GaAs), sapphire (Al₂O₃), zinc oxide (ZnO), and silicon carbide (SiC), for example, may be used for the different type substrate.

Fig. 3 is a schematic cross-sectional view showing a grown separation layer 12 in the present embodiment. Next, as shown in Figs. 1 and 3, separation layer 12 as a first gallium nitride layer is grown on a surface of base substrate 11 (step S2). Separation layer 12 is made of GaN. Here, a growth surface of separation layer 12 is preferably not parallel to the surface of base substrate 12, but an uneven surface for growth. A method of growing separation layer 12 is not particularly limited, and a vapor phase growth method, a liquid phase growth method such as sublimation, HVPE, MOCVD, and MBE (Molecular Beam Epitaxy) may be employed. HPVE is preferably employed.

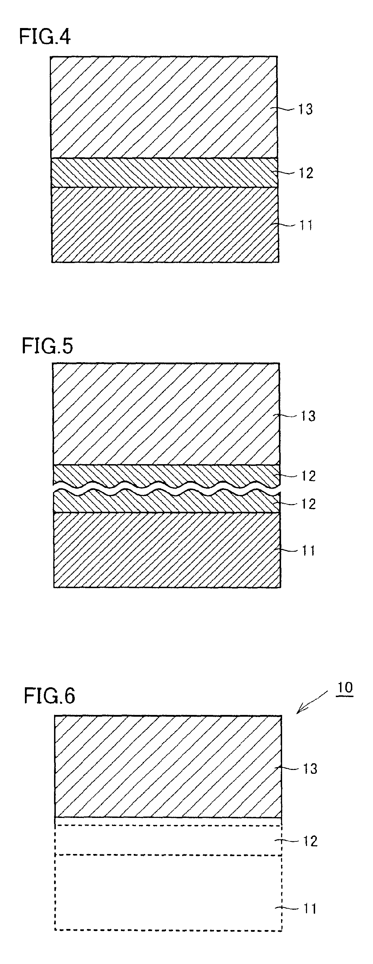

Separation layer 12 preferably has a thickness of not smaller than 200 nm and not greater than 750 nm. With a thickness of not smaller than 200 nm, impact applied to a GaN layer 13 (see Fig. 4) can be suppressed during removal of base substrate 11 which will be described later. With a thickness of not greater than 750 nm, a crystalline property of GaN layer 13 (see Fig. 4) can be improved after growth of GaN layer 13 which will be described later.

Fig. 4 is a schematic cross-sectional view showing the grown GaN layer in the present embodiment. Next, as shown in Figs. 1 and 4, GaN layer 13 less brittle than separation layer 12 as a second gallium nitride layer is grown (step S3). A method of growing GaN layer 13 is not particularly limited, and a method similar to the method of growing separation layer 12 is preferably employed from the viewpoint of simplifying steps S2 and S3 of growing separation layer 12 and GaN layer 13.

Brittleness of separation layer 12 and GaN layer 13 is now described. "Brittleness" refers to a property of fracturing without plastic deformation due to application of stress, and "highly brittle" means that stress applied until fracture is small. Accordingly, "GaN layer 13 is less brittle than separation layer 12" means that stress applied until separation layer 12 fractures is smaller than stress applied until GaN layer 13 fractures. Namely, separation layer 12 is more brittle than GaN layer 13. As an index of brittleness, a value of weight applied with a micro-compression test device or the like until each of separation layer 12 and GaN layer 13 fractures, for example, may be used as a value of applied stress. In the present embodiment, therefore, the value of stress applied until fracture is used as a value for evaluating "brittleness." In view of the above, either separation layer 12 or GaN layer 13 greater in this value of stress may be determined to be less brittle.

Specifically, separation layer 12 more brittle than GaN layer 13 can be grown by performing the following steps. As a first method, in step S2 of growing separation layer 12, separation layer 12 containing oxygen as a first dopant is grown, and in step S3 of growing GaN layer 13, GaN layer 13 containing oxygen as a second dopant is grown. Oxygen concentration in the first dopant is preferably higher than, 10 times or higher than oxygen concentration in the second dopant. The higher the concentration of oxygen doped into separation layer 12 and GaN layer 13, the less brittle. If the first dopant is 10 times or higher than the second dopant in concentration, separation layer 12 is much less brittle than GaN layer 13.

As a second method, in step S2 of growing separation layer 12, separation layer 12 containing silicon as a first dopant is grown, and in step S3 of growing GaN layer 13, GaN layer 13 containing silicon as a second dopant is grown. Silicon concentration in the first dopant is preferably higher than, 10 times or higher than silicon concentration in the second dopant. The higher the concentration of silicon doped into separation layer 12 and GaN layer 13, the less brittle. A growth surface of separation layer 12 is preferably not parallel to the surface of base substrate 11 but an uneven surface for growth so that an amount of doping into separation layer 12 is increased. If the first dopant is 10 times or higher than the second dopant in concentration, separation layer 12 is much less brittle than GaN layer 13.

As a third method, in step S2 of growing separation layer 12, separation layer 12 containing oxygen as a first dopant is grown, and in step S3 of growing GaN layer 13, the GaN layer containing silicon as a second dopant is grown. Oxygen concentration in the first dopant is preferably not smaller than 33/50 of, more preferably equal to or higher than, further preferably 10 times or higher than silicon concentration in the second dopant. A growth surface of separation layer 12 is preferably not parallel to the surface of base substrate 11 but an uneven surface for growth so that an amount of doping into separation layer 12 is increased. It is considered that oxygen enters a nitrogen site and silicon enters a gallium site in a GaN crystal. Since the difference in atomic radius between nitrogen and oxygen is larger than the difference in atomic radius between gallium and silicon, separation layer 12 has larger lattice strain than in GaN layer 13. Thus, by setting the oxygen concentration in the first dopant to not smaller than 33/50 of the silicon concentration in the second dopant, separation layer 12 is less brittle than GaN layer 13. If the first dopant is 10 times or higher than the second dopant in concentration, separation layer 12 is much less brittle than GaN layer 13.

As a fourth method, in step S2 of growing separation layer 12, separation layer 12 containing oxygen and silicon as a first dopant is grown, and in step S3 of growing GaN layer 13, GaN layer 13 containing silicon as a second dopant is grown. Oxygen concentration in the first dopant is equal to or higher than silicon concentration in the first dopant in separation layer 12 (i.e., the oxygen concentration accounts for a half or more of a sum of the oxygen concentration and the silicon concentration in separation layer 12), and the sum of the oxygen concentration and the silicon concentration in the first dopant is equal to or higher than silicon concentration in the second dopant. Further, the sum of the oxygen concentration and the silicon concentration in the first dopant is preferably higher than, more preferably 10 times or higher than the silicon concentration in the second dopant. A growth surface of separation layer 12 is preferably not parallel to the surface of base substrate 11 but an uneven surface for growth so that an amount of doping into separation layer 12 is increased. Since the difference in atomic radius between nitrogen and oxygen is larger than the difference in atomic radius between gallium and silicon, if separation layer 12 containing oxygen equal to or higher than silicon as a dopant has high impurity concentration, separation layer 12 has larger lattice strain than in GaN layer 13, and is thus less brittle than GaN layer 13. If the first dopant is 10 times or higher than the second dopant in concentration, separation layer 12 is much less brittle than GaN layer 13.

In the first to fourth methods described above, dopants doped into separation layer 12 and GaN layer 13 are preferably only the first dopant and the second dopant, respectively. In such case, brittleness of separation layer 12 and GaN layer 13 is readily adjusted with the first and second dopants.

GaN layer 13 can be grown by performing steps S1 to S3 described above. When a GaN substrate is manufactured with GaN layer 13, the following steps are further performed.

Next, base substrate 11 and separation layer 12 are removed from GaN layer 13 (step S4). A method of removal is not particularly limited, and a method such as cutting or grinding may be used.

Cutting herein refers to mechanically separating GaN layer 13 and separation layer 12 from each other by mechanically slicing an interface between GaN layer 13 and separation layer 12 with a slicer, a wire saw or the like having a peripheral cutting edge of an electrodeposited diamond wheel, by irradiating or spraying the interface between GaN layer 13 and separation layer 12 with laser pulses or water molecules, by cleavage along a crystal lattice surface of separation layer 12, or the like. In such cases, since separation layer 12 is brittle, separation layer 12 separates from GaN layer 13 under small impact.

Grinding herein refers to mechanically cutting base substrate 11 and separation layer 12 away with grinding equipment having a diamond grindstone or the like. In such case, since separation layer 12 is more brittle than GaN layer 13, separation layer 12 fractures prior to GaN layer 13 by being cracked or the like due to applied mechanical impact. As a result, separation layer 12 readily separates from GaN layer 13.

Fig. 5 is a schematic cross-sectional view showing separation layer 12 and GaN layer 13 cut from each other in the present embodiment. As shown in Fig. 5, separation layer 12 may adhere to GaN layer 13 during cutting, grinding, or the like. In such case, separation layer 12 adhering to GaN layer 13 is removed by polishing or the like. Since separation layer 12 is brittle, separation layer 12 can be removed from GaN layer 13 with small mechanical impact applied during polishing or the like.

A chemical method such as etching may be employed as a method of removing base substrate 11 and separation layer 12. In such case, separation layer 12 has a Young's modulus lower than that of GaN layer 13 and weaker chemical bond, and has lower chemical strength. Accordingly, chemical impact on GaN layer 13 can be suppressed.

Fig. 6 is a schematic cross-sectional view showing a GaN substrate 10 in the present embodiment. GaN substrate 10 shown in Fig. 6 can be manufactured by performing steps S1 to S4 described above.

Next, GaN layer 13 is polished from a side of the surface on which separation layer 12 was formed. This polishing is effective in making the surface of GaN substrate 10 a mirror surface, and is also effective in removing an affected layer formed on the surface of GaN substrate 10. This polishing may be omitted.

As described above, according to the method of growing a crystal in GaN layer 13 and the method of manufacturing GaN substrate 10 in the present embodiment, separation layer 12 less brittle than GaN layer 13 is formed between base substrate 11 and GaN layer 13 (step S2). Accordingly, impact applied to GaN layer 13 until base substrate 11 and separation layer 12 are removed from GaN layer 13 can be reduced, thereby preventing occurrence of a crack in GaN layer 13. For separation layer 12 to fracture prior to GaN layer 13 and base substrate 11 when base substrate 11 and separation layer 12 are removed from GaN layer 13, separation layer 12 is preferably less brittle than base substrate 11 and GaN layer 13.

In the method of growing a crystal in GaN layer 13 in the present embodiment, preferably, the oxygen concentration in the dopant in separation layer 12 is higher than the oxygen concentration in the dopant in GaN layer 13. Further, the silicon concentration in the dopant in separation layer 12 is higher than the silicon concentration in the dopant in GaN layer 13. Furthermore, the oxygen concentration in separation layer 12 is not smaller than 33/50 of the silicon concentration in the dopant in GaN layer 13. Moreover, the oxygen concentration in the dopant in separation layer 12 is equal to or higher than the silicon concentration in the dopant in separation layer 12, and the sum of the oxygen concentration and the silicon concentration in the dopant in separation layer 12 is equal to or higher than the silicon concentration in the dopant in GaN layer 13.

Such impurity doping into separation layer 12 produces larger lattice strain in separation layer 12 than in GaN layer 13, thereby forming separation layer 12 more brittle than GaN layer 13. Consequently, brittle separation layer 12 readily separates from the GaN layer under small impact. Therefore, occurrence of a crack in GaN layer 13 can be prevented.

### (Second Embodiment)

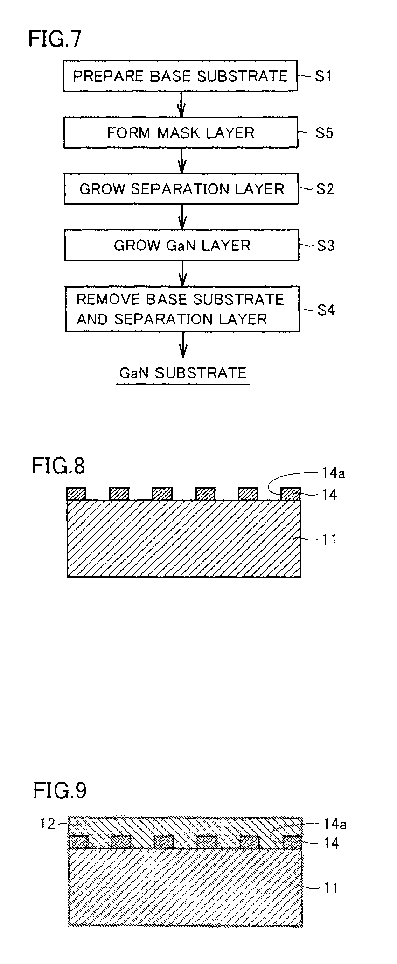

Fig. 7 is a flowchart illustrating a method of manufacturing a GaN substrate in the present embodiment. As shown in Fig. 7, the method of manufacturing a GaN substrate in the present embodiment basically includes steps similar to those in the method of manufacturing a GaN substrate in the first embodiment, and is different in that a mask layer is further formed.

Specifically, as shown in Fig. 2, first, base substrate 11 is prepared as in the first embodiment (step S1).

Fig. 8 is a schematic cross-sectional view showing a formed mask layer 14 in the present embodiment. Next, as shown in Figs. 7 and 8, between preparation step S1 and step S2 of growing separation layer 12, mask layer 14 having an opening 14a is formed on base substrate 11 (step S5).

A material constituting mask layer 14 preferably includes at least one substance selected from the group consisting of silicon dioxide, silicon nitride, titanium, chromium, iron, and platinum.

A method of forming mask layer 14 having the opening is not particularly limited, and photolithography may be employed, for example. In the present embodiment, a metal layer composed of metal particles is formed with vapor deposition and subjected to heat treatment, to form porous mask layer 14. The metallic particles preferably have a particle size of not smaller than 1 nm and not greater than 50 nm when measured with a small-angle scattering measurement device. With a size of not smaller than 1 nm, porous mask layer 14 can be formed even at a reduced heat treatment temperature, so that damage to base substrate 11 due to the heat treatment can be suppressed. With a size of not greater than 50 nm, elimination of the metallic particles during the heat treatment can be prevented, so that porous mask layer 14 can be formed. Heat treatment is preferably conducted at not lower than 800°C and not higher than 1300°C under normal pressure.

Fig. 9 is a schematic cross-sectional view showing grown separation layer 12 in the present embodiment. Next, as shown in Figs. 7 and 9, separation layer 12 is grown on base substrate 11. In the present embodiment, separation layer 12 is formed on base substrate 11 exposed through opening 14a of mask layer 14, and separation layer 12 is further grown to cover mask layer 14. Here, a surface of separation layer 12 is preferably not parallel to the surface of base substrate 11 but an uneven surface for growth so that an amount of doping into separation layer 12 is increased.

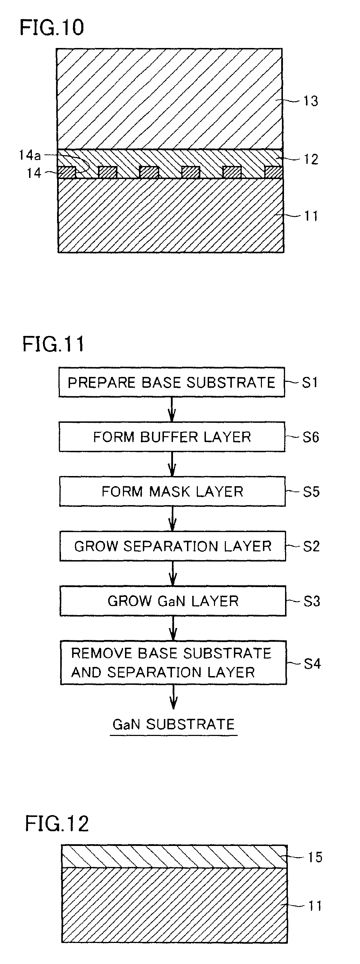

Fig. 10 is a schematic cross-sectional view showing a grown GaN layer 13 in the present embodiment. Next, as shown in Figs. 7 and 10, GaN layer 13 is grown as in the first embodiment (step S3). As a result, a crystal in GaN layer 13 can be grown.

When a GaN substrate is manufactured, additionally, base substrate 11 and separation layer 12 are removed from GaN layer 13 as in the first embodiment (step S4).

The remaining method of growing a crystal in GaN layer 13 and method of manufacturing the GaN substrate have steps similar to those in the method of growing a crystal in GaN layer 13 and the method of manufacturing the GaN substrate in the first embodiment. Thus, the same members are denoted with the same reference characters, and description thereof will not be repeated.

As described above, the method of growing a crystal in GaN layer 13 and the method of manufacturing the GaN substrate in the present embodiment further include step S5 of forming mask layer 14 having opening 14a on base substrate 11 between preparation step S1 and step S2 of growing separation layer 12.

According to the present embodiment, even when base substrate 11 including dislocation is prepared, an area of contact between separation layer 12 and base substrate 11 can be reduced, thereby suppressing transfer of the dislocation present in base substrate 11 to separation layer 12. Transfer of dislocation to GaN layer 13 grown on separation layer 12 can thus be suppressed, thereby reducing dislocation in GaN layer 13. Therefore, occurrence of a crack can be suppressed and dislocation can be reduced in the GaN substrate manufactured with GaN layer 13.

Particularly, in step S1 of preparing base substrate 11, a different type substrate made of a material different from GaN is preferably prepared as base substrate 11. When separation layer 12 made of GaN is formed on base substrate 11 which is a different type substrate made of a material different from GaN, dislocation occurs in separation layer 12 due to the difference in lattice constant. Since occurrence of dislocation in separation layer 12 can be reduced by forming mask layer 14 as in the present embodiment, it is particularly effective when base substrate 11 is a different type substrate.

### (Third Embodiment)

Fig. 11 is a flowchart illustrating a method of manufacturing a GaN substrate in the present embodiment. As shown in Fig. 11, the method of manufacturing a GaN substrate in the present embodiment basically includes steps similar to those in the method of manufacturing a GaN substrate in the first embodiment, and is different in that a buffer layer and a mask layer are formed.

Specifically, as shown in Fig. 2, first, base substrate 11 is prepared as in the first embodiment (step S1).

Fig. 12 is a schematic cross-sectional view showing a formed buffer layer 15 in the present embodiment. Next, as shown in Figs. 11 and 12, between preparation step S1 and step S2 of growing separation layer 12, buffer layer 15 is formed on base substrate 11 (step S6).

A method of forming buffer layer 15 is not particularly limited, and buffer layer 15 can be formed by being grown with a method similar to the method of growing separation layer 12 and GaN layer 13, for example. Buffer layer 15 is preferably made of GaN from the viewpoint of growing separation layer 12 and GaN layer 13 having a favorable crystalline property.

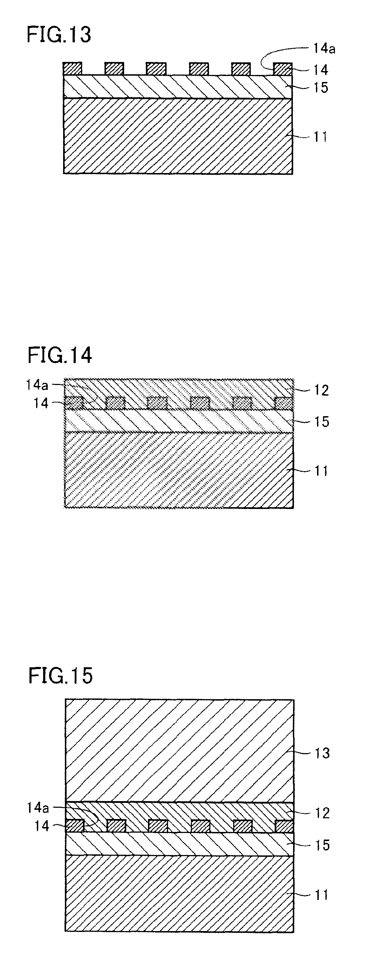

Fig. 13 is a schematic cross-sectional view showing a formed mask layer 14 in the present embodiment. Next, as shown in Figs. 11 and 13, mask layer 14 having opening 14a is formed on buffer layer 15 as in the second embodiment (step S5).

Fig. 14 is a schematic cross-sectional view showing formed separation layer 12 in the present embodiment. Next, as shown in Figs. 11 and 14, mask layer 14 having opening 14a is formed on buffer layer 15 formed on base substrate 11. The present embodiment is different in that separation layer 12 is formed on buffer layer 15 exposed through opening 14a to cover mask layer 14, and a material constituting mask layer 14 and a method of forming mask layer 14 are similar to those in the second embodiment. A growth surface of separation layer 12 is preferably not parallel to the surface of the base substrate but an uneven surface for growth so that an amount of doping into separation layer 12 is increased.

Fig. 15 is a schematic cross-sectional view showing a grown GaN layer 13 in the present embodiment. Next, as shown in Figs. 11 and 15, GaN layer 13 is grown as in the first embodiment (step S3). As a result, a crystal in GaN layer 13 can be grown.

When a GaN substrate is manufactured, additionally, base substrate 11 and separation layer 12 are removed from GaN layer 13 as in the first embodiment (step S4).

The remaining method of growing a crystal in GaN layer 13 and method of manufacturing the GaN substrate have steps similar to those in the method of growing a crystal in GaN layer 13 and the method of manufacturing the GaN substrate in the first or second embodiment. Thus, the same members are denoted with the same reference characters, and description thereof will not be repeated.

As described above, the method of growing a crystal in GaN layer 13 and the method of manufacturing the GaN substrate in the present embodiment further include, between preparation step S1 and step S3 of growing separation layer 12, step S6 of forming buffer layer 15 on base substrate 11, and step S7 of forming mask layer 14 having opening 14a on buffer layer 15.

According to the present embodiment, even when base substrate 11 including dislocation is prepared, an area of contact between separation layer 12 and buffer layer 15 can be reduced. Thus, even if the dislocation present in base substrate 11 is transferred to buffer layer 15, transfer of the dislocation present in base substrate 11 to separation layer 12 can be suppressed. Accordingly, transfer of dislocation to GaN layer 13 grown on separation layer 12 can be suppressed, thereby reducing dislocation in GaN layer 13.

In addition, when a layer to be mask layer 14 is formed and subsequently subjected to heat treatment to form mask layer 14, buffer layer 15 formed on base substrate 11 can protect base substrate 11 during the heat treatment. As a result, separation layer 12 having a favorable crystalline property can be grown, to grow GaN layer 13 having a favorable crystalline property on separation layer 12.

Therefore, occurrence of a crack can be suppressed and dislocation can be reduced in the GaN substrate manufactured with GaN layer 13.

Again in the present embodiment, in step S1 of preparing base substrate 11, a different type substrate made of a material different from GaN is preferably prepared as base substrate 11 as in the second embodiment.

### [Example 1]

In the present example, an effect of growth of the first gallium nitride layer (separation layer 12) with low brittleness was studied. Specifically, occurrence of a crack after a crystal in GaN layer 13 was grown in accordance with the method of growing a crystal in the GaN layer in the first embodiment described above and base substrate 11 and separation layer 12 were removed from GaN layer 13 was studied.

First, base substrate 11 made of GaAs having a diameter of 2 inches was prepared (step S1). Then, separation layer 12 was grown on base substrate 11 with HVPE (step S2), and thereafter GaN layer 13 was grown on separation layer 12 with HVPE (step S3).

More specifically, an ammonia (NH₃) gas, a hydrogen chloride (HCl) gas, and gallium (Ga) were prepared as materials for separation layer 12 and GaN layer 13, an oxygen gas was prepared as a doping gas, and hydrogen with a purity of 99.999% or higher was prepared as a carrier gas. Then, a gallium chloride (GaCl) gas was produced by reaction of the hydrogen chloride gas and the gallium such that Ga+HCl→GaCl+1/2H₂. This gallium chloride gas and the ammonia gas were fed together with the carrier gas and the doping gas to impinge on the surface of base substrate 11 on which separation layer 12 and GaN layer 13 are to be grown, to cause a reaction such that GaCl+NH₃→GaN+HCl+H₂ on the surface at 1050°C. By adjusting a flow rate of the doping gas, separation layer 12 having oxygen concentration of 6.0×10¹⁹ cm⁻³ and a thickness of 500 nm and GaN layer 13 having oxygen concentration of 5.0×10¹⁸ cm⁻³ and a thickness of 500 µm were grown. Impurity analysis was conducted with the SIMS analysis. Separation layer 12 and GaN layer 13 were not doped with impurities other than oxygen, and impurities that exist with concentration one-tenth or higher than the oxygen concentration were not detected by the SIMS impurity analysis.

Next, base substrate 11 and separation layer 12 were removed from GaN layer 13 (step S4). More specifically, separation layer 12 was irradiated with laser pulses and separated from GaN layer 13, thus removing separation layer 12 and base substrate 11 from GaN layer 13. Consequently, GaN substrate 10 of 2 inches formed by GaN layer 13 was manufactured.

### (Measurement Method)

Vickers hardness of each of separation layer 12 and GaN layer 13 was measured in accordance with JIS R1607. The results are shown in Table 1 below.

In addition, weight was applied to each of separation layer 12 and GaN layer 13 with a micro-compression test device, and a weight at the time of separation was measured. The results are shown in Table 1 below.

Moreover, presence or absence of occurrence of a crack was determined for obtained GaN substrate 10. Specifically, a 20-times objective lens of a differential interference optical microscope was used to determine whether a crack having a length of not smaller than 500 µm had occurred in the entire surface of GaN substrate 10 of 2 inches except for a periphery of 5 mm.

**[Table 1]**

| | Separation layer | GaN layer |
|---|---|---|
| Carrier concentration | 6.0×10¹⁹ | 5.0×10¹⁸ |
| Vickers hardness (C surface) | 1400 | 1500 |
| Weight | separated with indentation at 20g | separated with indentation at 200g |

### (Measurement Results)

As shown in Table 1, the weight when separation layer 12 separated from base substrate 11 was much smaller than the weight when GaN layer 13 separated from separation layer 12. Based on the results, it was found that since separation layer 12 more brittle than GaN layer 13 could be formed by adjusting carrier concentrations of separation layer 12 and GaN layer 13, the Vickers hardness was not affected but the weight at the time of separation could be significantly affected. In addition, since it was unnecessary to apply a large weight to separation layer 12 when removing base substrate 11, a crack did not occur in GaN substrate 10 in the present example.

In view of the above, it was confirmed in the present example that occurrence of a crack in GaN layer 13 could be prevented when base substrate 11 and separation layer 12 were removed because separation layer 12 with low brittleness could be formed by growing separation layer 12 doped with oxygen in concentration higher than in GaN layer 13.

### [Example 2]

In the present example, an effect of growth of the first gallium nitride layer (separation layer 12) with low brittleness was studied. Specifically, occurrence of a crack after a crystal in GaN layer 13 was grown in accordance with the method of growing a crystal in the GaN layer in the first embodiment described above and base substrate 11 and separation layer 12 were removed from GaN layer 13 was studied.

### (Samples 1 to 14)

As sample 1, a GaN substrate was manufactured with a method similar to that in the first example described above. As samples 2 to 14, GaN substrates were manufactured basically with a method similar to that in the first example described above, however, are different only in that separation layer 12 and GaN layer 13 were doped with impurities shown in Table 2 below and grown to have carrier concentrations shown in Table 2 below.

Specifically, in sample 2, separation layer 12 contained silicon as a first dopant and GaN layer 13 contained silicon as a second dopant, and silicon concentration in the first dopant was higher than silicon concentration in the second dopant.

In sample 3, separation layer 12 contained oxygen as a first dopant and GaN layer 13 contained silicon as a second dopant, and oxygen concentration in the first dopant was higher than silicon concentration in the second dopant.

In sample 4, separation layer 12 contained oxygen as a first dopant and GaN layer 13 contained silicon as a second dopant, and oxygen concentration in the first dopant was equal to silicon concentration in the second dopant.

In sample 5, separation layer 12 contained oxygen as a first dopant and GaN layer 13 contained silicon as a second dopant, and oxygen concentration in the first dopant was set to 0.7 of silicon concentration in the second dopant.

In sample 6, separation layer 12 contained oxygen as a first dopant and GaN layer 13 contained silicon as a second dopant, and oxygen concentration in the first dopant was set to 33/50 of silicon concentration in the second dopant.

In sample 7, separation layer 12 contained oxygen and silicon as a first dopant and GaN layer 13 contained silicon as a second dopant, oxygen concentration in the first dopant was higher than silicon concentration in the first dopant in separation layer 12, and a sum of the oxygen concentration and the silicon concentration in the first dopant was equal to silicon concentration in the second dopant.

In samples 8 and 10, separation layer 12 contained oxygen and silicon as a first dopant and GaN layer 13 contained silicon as a second dopant, oxygen concentration in the first dopant was equal to silicon concentration in the first dopant in separation layer 12, and a sum of the oxygen concentration and the silicon concentration in the first dopant was equal to silicon concentration in the second dopant.

In sample 9, separation layer 12 contained oxygen and silicon as a first dopant and GaN layer 13 contained silicon as a second dopant, oxygen concentration in the first dopant was higher than silicon concentration in the first dopant in separation layer 12, and a sum of the oxygen concentration and the silicon concentration in the first dopant was higher than silicon concentration in the second dopant.

In sample 11, separation layer 12 contained oxygen as a first dopant and GaN layer 13 contained oxygen as a second dopant, and oxygen concentration in the first dopant was equal to oxygen concentration in the second dopant.

In sample 12, separation layer 12 contained silicon as a first dopant and GaN layer 13 contained silicon as a second dopant, and silicon concentration in the first dopant was equal to silicon concentration in the second dopant.

In sample 13, separation layer 12 contained oxygen as a first dopant and GaN layer 13 contained silicon as a second dopant, and oxygen concentration in the first dopant was lower than 33/50 of oxygen concentration in the second dopant.

In sample 14, separation layer 12 contained oxygen as a first dopant and silicon and GaN layer 13 contained silicon as a second dopant, oxygen concentration in the first dopant was lower than silicon concentration in the first dopant in separation layer 12, and a sum of the oxygen concentration and the silicon concentration in the first dopant was equal to silicon concentration in the second dopant.

In samples 1 to 14, separation layer 12 and GaN layer 13 were not doped with impurities other than silicon and oxygen shown in Tables 2 and 3, and other impurities having concentration one-tenth or higher than the concentration of silicon and the concentration of the oxygen doped into separation layer 12 and GaN layer 13 were not detected by the SIMS impurity analysis.

### (Measurement Method)

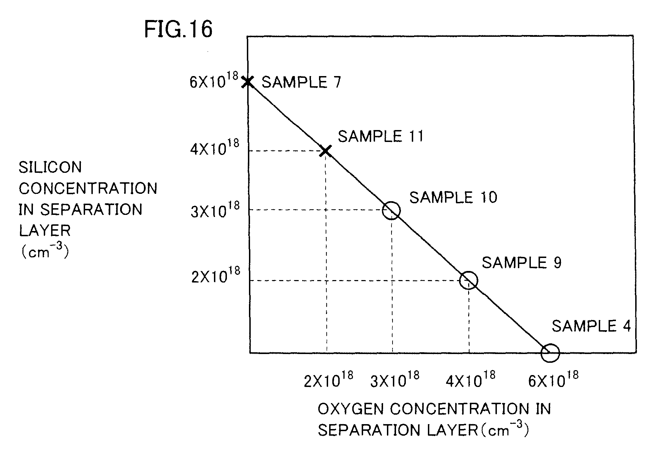

For samples 1 to 14, presence or absence of occurrence of a crack was determined as in example 1. The results are shown in Tables 2, 3 below and Fig. 16. A unit of the concentration in Tables 2 and 3 is cm⁻³. Fig. 16 illustrates relation between oxygen concentration and silicon concentration in separation layer 12 for samples 4, 7 and 9 to 11 in which GaN layer 13 was doped with silicon in concentration of 6x 10¹⁸cm⁻³ in the present example.

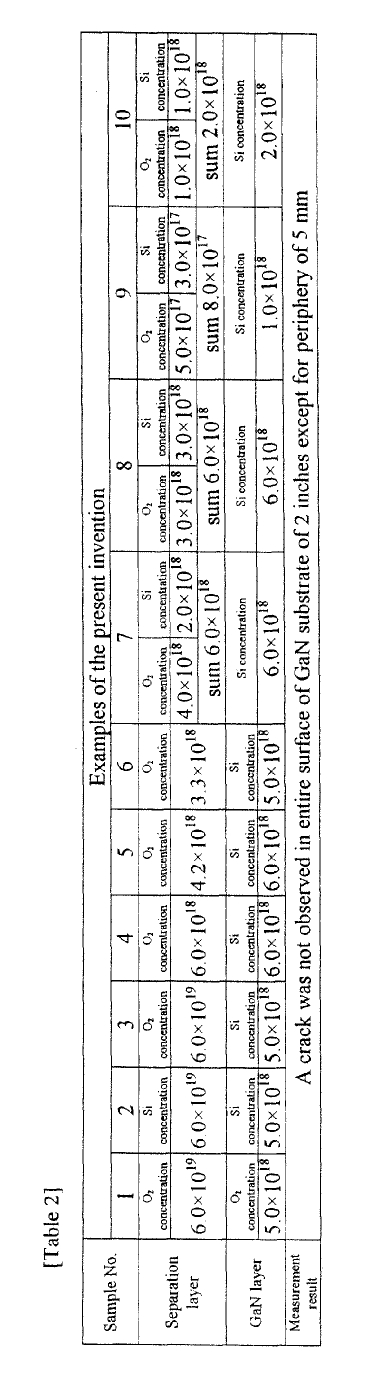

**[Table 3]**

| Sample No. | Comparative examples | | | | |
|---|---|---|---|---|---|
| | 11 | 12 | 13 | 14 | |
| Separation layer | O₂ concentration | Si concentration | O₂ concentration | O₂ concentration | Si concentration |
| | 6.0×10¹⁸ | 6.0×10¹⁸ | 3.5×10¹⁸ | 2.0×10¹⁸ | 4.0×10¹⁸ |
| | | | | sum 6.0×10¹⁸ | |
| GaN layer | O₂ concentration | Si concentration | Si concentration | Si concentration | |
| | 6.0×10¹⁸ | 6.0×10¹⁸ | 6.0×10¹⁸ | 6.0×10¹⁸ | |
| Measurement result | A plurality of cracks occurred from periphery in in-plane direction | | | | |

### (Measurement Results)

As shown in Tables 2 and 3, a crack did not occur in the GaN substrates of samples 1 to 10. On the other hand, a crack occurred in the GaN substrates of samples 11 to 14. Based on these results, it is considered that prevention of occurrence of a crack was owing to the fact that the separation layer was less brittle than the GaN layer.

Moreover, as shown in Tables 2, 3 and Fig. 16, it was confirmed that occurrence of a crack in the GaN layer could be effectively suppressed when: (i) separation layer 12 contained oxygen as a first dopant and GaN layer 13 contained oxygen as a second dopant, and oxygen concentration in the first dopant was higher than oxygen concentration in the second dopant; (ii) separation layer 12 contained silicon as a first dopant and the GaN layer contained silicon as a second dopant, and silicon concentration in the first dopant was higher than silicon concentration in the second dopant; (iii) separation layer 12 contained oxygen as a first dopant and GaN layer 13 contained silicon as a second dopant, and oxygen concentration in the first dopant was not smaller than 33/50 of silicon concentration in the second dopant; and (iv) separation layer 12 contained oxygen and silicon as a first dopant and GaN layer 13 contained silicon as a second dopant, oxygen concentration in the first dopant was equal to or higher than silicon concentration in the first dopant in separation layer 12, and a sum of the oxygen concentration and the silicon concentration in the first dopant was equal to or higher than silicon concentration in the second dopant.

It should be understood that the embodiments and the examples disclosed herein are illustrative and non-restrictive in every respect. The scope of the present invention is defined by the terms of the claims, rather than the embodiments above, and is intended to include any modifications within the scope and meaning equivalent to the terms of the claims.

## Claims

1. A method of growing a gallium nitride crystal, comprising the steps of:
preparing a base substrate (11) (S1);
growing a first gallium nitride layer (12) on said base substrate (11) (S2); and
growing a second gallium nitride layer (13) less brittle than said first gallium nitride layer (12) (S3).

2. The method of growing a gallium nitride crystal according to claim 1,
wherein
said first gallium nitride layer (12) contains oxygen as a first dopant,
said second gallium nitride layer (13) contains oxygen as a second dopant, and oxygen concentration in said first dopant is higher than oxygen concentration in said second dopant.

3. The method of growing a gallium nitride crystal according to claim 1,
wherein
said first gallium nitride layer (12) contains silicon as a first dopant,
said second gallium nitride layer (13) contains silicon as a second dopant, and
silicon concentration in said first dopant is higher than silicon concentration in said second dopant.

4. The method of growing a gallium nitride crystal according to claim 1,
wherein
said first gallium nitride layer (12) contains oxygen as a first dopant,
said second gallium nitride layer (13) contains silicon as a second dopant, and
oxygen concentration in said first dopant is not smaller than 33/50 of silicon concentration in said second dopant.

5. The method of growing a gallium nitride crystal according to claim 1,
wherein
said first gallium nitride layer (12) contains oxygen and silicon as a first dopant,
said second gallium nitride layer (13) contains silicon as a second dopant, and
oxygen concentration in said first dopant is equal to or higher than silicon concentration in said first dopant in said first gallium nitride layer (12), and a sum of the oxygen concentration and the silicon concentration in said first dopant is equal to or higher than silicon concentration in said second dopant.

6. The method of growing a gallium nitride crystal according to claim 1,
wherein
said base substrate (11) is made of a material different from gallium nitride.

7. The method of growing a gallium nitride crystal according to claim 1, further comprising the step of forming a mask layer (14) having an opening (14a) on said base substrate (11) (S5) between said step of preparation (S1) and said step of growing said first gallium nitride layer (12) (S2).

8. The method of growing a gallium nitride crystal according to claim 1, further comprising the steps of, between said step of preparation (S1) and said step of growing said first gallium nitride layer (12) (S2);
forming a buffer layer (15) on said base substrate (11) (S6); and
forming a mask layer (14) having an opening (14a) on said buffer layer (15) (S5).

9. The method of growing a gallium nitride crystal according to claim 7,
wherein
a material constituting said mask layer (14) includes at least one substance selected from the group consisting of silicon dioxide, silicon nitride, titanium, chromium, iron, and platinum.

10. A method of manufacturing a gallium nitride substrate, comprising the steps of:
growing said first and second gallium nitride layers (12, 13) with the method of growing a gallium nitride crystal according to claim 1; and
removing said base substrate (11) and said first gallium nitride layer (12) from said second gallium nitride layer (13) (S4).
